# DEMANDE DE BREVET EUROPEEN

(11) **EP 2 211 381 A1**
(43) Date de publication de la demande: **28.07.2010**
(21) Numéro de dépôt: 10150992.5
(22) Date de dépôt: 18.01.2010
(51) Int. Cl.: H01L 21/762

(54) **Caisson isolé à faible capacité parasite pour composants électroniques**

(30) Priorité: 23.01.2009 FR 0950420
(71) Demandeur: STMicroelectronics (Tours) SAS, 37100 Tours (FR)
(72) Inventeur: Poveda, Patrick, 37110, Villedomer (FR); Morillon, Benjamin, 37100, Tours (FR); Bruno, Erwan, 37510, Ballan-Mire (FR)
(74) Mandataire: de Beaumont, Michel

(57) **Abrégé**

L'invention concerne une structure comprenant au moins un composant électronique formé dans un empilement semi-conducteur comprenant une couche enterrée de silicium fortement dopé d'un premier type de conductivité (35) s'étendant sur un substrat de silicium faiblement dopé d'un second type de conductivité (31) et une tranchée isolante verticale (41) entourant le composant. La tranchée (41) pénètre dans le substrat de silicium (31), en dessous de la couche de silicium (35), sur une profondeur supérieure à l'épaisseur de la zone de charge d'espace dans le substrat de silicium (31).

## Description

### Domaine de l'invention

La présente invention concerne des composants électroniques formés dans et sur une structure semiconductrice et isolés entre eux. Plus particulièrement, la présente invention concerne une structure dans laquelle les capacités parasites entre composants et entre composant et substrat sont réduites. La présente invention concerne également un procédé de fabrication d'une telle structure.

### Exposé de l'art antérieur

De façon classique, des composants électroniques formés dans et sur un substrat semiconducteur, par exemple des composants de puissance, sont isolés, en surface de l'empilement, par des jonctions PN. Si le substrat est de type N, des régions P isolent latéralement les composants électroniques les uns des autres. Ce type d'isolement présente l'inconvénient de consommer une surface importante pour être efficace. En effet, la largeur de la région P est au moins égale à deux fois sa profondeur. De plus, on considère généralement qu'un isolement par jonction PN n'est pas optimal du point de vue des capacités parasites entre composant et substrat.

Ainsi, pour limiter la surface occupée et réduire les capacités parasites, il a été proposé de former des composants électroniques dans et sur des substrats de type silicium sur isolant (SOI) et d'isoler les composants entre eux à l'aide de matériaux diélectriques.

La figure 1 illustre une de ces structures proposée par la demanderesse dans la demande de brevet publiée sous le numéro FR 2 914 497. Deux diodes D1 et D2 sont formées côte à côte dans une structure de type SOI qui comprend une couche semiconductrice dopée de type N formée sur un substrat semiconducteur 1 avec interposition d'une couche isolante 3. Les diodes D1 et D2 sont isolées latéralement par des régions isolantes 5, par exemple en oxyde de silicium, qui traversent la couche semiconductrice et rejoignent la couche isolante 3. Chaque diode est ainsi réalisée dans un caisson semiconducteur 7 dopé de type N en surface duquel est formée une région 9 dopée de type P. Chaque caisson 7 est entouré (fond, parois latérales et une partie de sa surface supérieure) d'une région 11 fortement dopée de type N (N⁺). Un contact d'anode 13 et un contact de cathode 15 sont formés, respectivement, sur les régions 9 et 11 de la diode D1 et un contact d'anode 17 et un contact de cathode 19 sont formés, respectivement, sur les régions 9 et 11 de la diode D2. La couche 3 et les régions isolantes 5 ont par exemple des épaisseurs supérieures à 2 µm et permettent que les capacités parasites entre composants et entre composant et substrat soient très faibles.

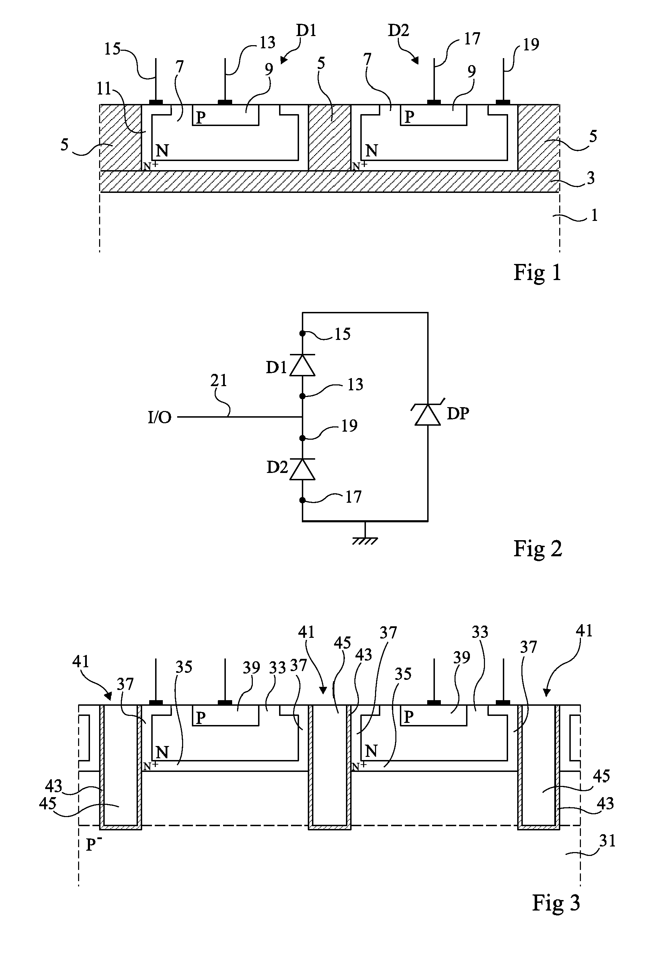

La figure 2 est un schéma électrique illustrant un exemple d'un dispositif de protection d'une ligne de transmission de données 21 (I/O) contre des surtensions. Le dispositif de la figure 2 comprend deux diodes faible capacité D1 et D2 et une diode de protection DP. La diode D2 a sa cathode 19 connectée à la ligne 21 et son anode 17 connectée à la masse. Lorsqu'une surtension négative apparaît sur la ligne 21, la diode D2 est polarisée en direct et devient passante. La diode D1 et la diode de protection DP sont placées, en série, en parallèle de la diode D2. La diode D1 a son anode 13 connectée à la ligne 21 et sa cathode 15 connectée à la cathode de la diode de protection DP. L'anode de la diode de protection DP est connectée à la masse. Lorsqu'une surtension positive supérieure à la tension d'avalanche de la diode de protection DP apparaît sur la ligne 21, cette diode de protection DP entre en avalanche et laisse passer le courant, la diode D1 étant également polarisée en direct.

On souhaite généralement que les circuits de protection contre les surtensions tels que celui de la figure 2 affectent le moins possible les signaux circulant dans la ligne. Pour cela, il est nécessaire que les capacités parasites liées au circuit de protection soient les plus faibles possibles. Ainsi, les diodes de protection D1 et D2 peuvent correspondre aux diodes de la figure 1 et la diode de protection DP peut également être formée dans un caisson similaire.

Cependant, des structures à caissons de type SOI ont plusieurs inconvénients. Les tranches de type SOI coûtent relativement cher par rapport aux tranches massives si on impose des caractéristiques particulières à chacun des éléments de la tranche. De plus, pour permettre un bon isolement vertical, on utilise généralement des tranches comprenant une couche d'oxyde enterrée épaisse, ce qui peut provoquer une déformation importante rendant le traitement des tranches délicat lors des opérations de fabrication.

Ainsi, un besoin existe d'une structure permettant l'isolement entre des composants électroniques, qui soit relativement peu coûteuse, à faible encombrement, et qui limite les capacités parasites entre composants et entre composant et substrat.

### Résumé

Un objet d'un mode de réalisation de la présente invention est de prévoir une structure à faible coût et peu encombrante comprenant des composants électroniques isolés entre eux.

Un autre objet d'un mode de réalisation de la présente invention est de prévoir une structure dans laquelle les capacités parasites entre composants et entre composant et substrat sont très faibles.

Un autre objet d'un mode de réalisation de la présente invention est de prévoir un procédé de fabrication d'une telle structure.

Ainsi, un mode de réalisation de la présente invention prévoit une structure comprenant au moins un composant électronique formé dans un empilement semiconducteur comprenant une couche enterrée de silicium fortement dopé d'un premier type de conductivité s'étendant sur un substrat de silicium faiblement dopé d'un second type de conductivité et une tranchée isolante verticale entourant le composant, la tranchée pénétrant, dans le substrat de silicium, en dessous de la couche de silicium, sur une profondeur supérieure à l'épaisseur de la zone de charge d'espace dans le substrat de silicium.

Selon un mode de réalisation de la présente invention, le substrat de silicium est dopé à une concentration de dopants inférieure à 8,5.10¹³ atomes/cm³ et la couche de silicium enterrée est dopée à une concentration de dopants supérieure à 10¹⁹ atomes/cm³.

Selon un mode de réalisation de la présente invention, la zone de charge d'espace a une épaisseur comprise entre 1 µm et 3,3 µm.

Selon un mode de réalisation de la présente invention, la structure comprend en outre des régions fortement dopées du premier type de conductivité formées le long de la tranchée, au-dessus de la couche fortement dopée du premier type de conductivité.

Selon un mode de réalisation de la présente invention, la tranchée isolante a des parois isolées et est remplie de silicium polycristallin.

Selon un mode de réalisation de la présente invention, le composant électronique est une diode formée dans une couche de silicium supérieure du premier type de conductivité s'étendant sur la couche de silicium fortement dopé du premier type de conductivité.

Selon un mode de réalisation de la présente invention, le premier type de conductivité est le type N.

Un mode de réalisation de la présente invention prévoit en outre un procédé de fabrication d'une structure semiconductrice destinée à contenir un composant électronique, comprenant les étapes successives suivante :
former une couche de silicium supérieure s'étendant sur un substrat de silicium faiblement dopé d'un second type de conductivité avec interposition d'une couche enterrée de silicium fortement dopé du premier type de conductivité ;
réaliser une tranchée, selon le contour du composant, dans la couche de silicium supérieure ;
doper, du premier type de conductivité, les parois de la couche de silicium supérieure à partir de la tranchée ;
prolonger la tranchée dans le substrat de silicium, sur une profondeur supérieure à l'épaisseur de la zone de charge d'espace dans le substrat de silicium ; et
former, sur les parois et le fond de la tranchée, une couche isolante.

Selon un mode de réalisation de la présente invention, le procédé comprend en outre une étape de comblement de la tranchée par du silicium polycristallin.

Selon un mode de réalisation de la présente invention, la couche enterrée de silicium fortement dopé du premier type de conductivité est formée par implantation/diffusion de dopants en surface du substrat de silicium et la couche de silicium supérieure est formée par épitaxie sur la couche de silicium enterrée.

### Brève description des dessins

Ces objets, caractéristiques et avantages, ainsi que d'autres seront exposés en détail dans la description suivante de modes de réalisation particuliers faite à titre non-limitatif en relation avec les figures jointes parmi desquelles :
la figure 1, précédemment décrite, illustre une structure connue comprenant des composants électroniques isolés entre eux ;
la figure 2, précédemment décrite, illustre un exemple de circuit connu de protection d'une ligne de transmission de données contre des surtensions ;
la figure 3 illustre une structure comprenant des composants électroniques isolés entre eux selon un mode de réalisation de la présente invention ; et
les figures 4A à 4G illustrent des résultats d'étapes d'un procédé de fabrication de la structure de la figure 3 selon un mode de réalisation de la présente invention.

Par souci de clarté, de mêmes éléments ont été désignés par de mêmes références aux différentes figures et, de plus, comme cela est habituel dans la représentation des circuits intégrés, les diverses figures ne sont pas tracées à l'échelle.

### Description détaillée

La figure 3 illustre une structure comprenant des composants électroniques isolés entre eux selon un mode de réalisation de la présente invention.

Sur un substrat 31 de silicium faiblement dopé de type P (P⁻) sont formés deux caissons 33 de silicium dopé de type N. En figure 3, les composants électroniques représentés sont des diodes, D1 et D2, mais on comprendra que tout composant électronique pourra être formé dans les caissons 33. Une couche 35 de silicium fortement dopé de type N (N⁺) est formée à l'interface entre les caissons 33 et le substrat 31. Des régions 37 fortement dopées de type N s'étendent sur les parois latérales des caissons 33 et sur une partie de leurs surfaces supérieures. Des régions d'anode 39 des diodes D1 et D2, dopées de type P, sont formées en surface des caissons 33. Les caissons 33 sont isolés latéralement par des tranchées isolantes 41 qui pénètrent dans le substrat 31. Dans l'exemple représenté, les parois et le fond des tranchées 41 sont recouverts d'une couche isolante 43, par exemple en oxyde de silicium, et l'espace restant dans les tranchées 41 est rempli de silicium polycristallin 45 ou de tout autre matériau permettant le comblement de cet espace. A titre d'exemple de valeurs numériques, les caissons 33 peuvent avoir une épaisseur d'environ 10 µm et la couche 35 fortement dopée de type N une épaisseur d'environ 5 µm.

L'association du substrat 31 faiblement dopé de type P et de la couche 35 fortement dopée de type N forme une zone de charge d'espace qui s'étend profondément dans le substrat 31, du fait de la différence de dopage entre ces régions. La limite de cette zone de charge d'espace est représentée en pointillés en figure 3. Les dopages de la couche 35 et du substrat 31 sont prévus de façon que la zone de charge d'espace dans le substrat 31 ait une épaisseur supérieure à environ 3 µm. Par exemple, ces dopages sont relativement supérieur à 10¹⁹ atomes/cm³ pour la couche 35 et inférieur à 8,5.10¹³ atomes/cm³ pour le substrat 31, par exemple compris entre 8.10¹² atomes/cm³ et 8,5.10¹³ atomes/cm³. Une zone de charge d'espace ayant une épaisseur de 8 µm équivaut, en terme de capacité parasite, à une couche d'oxyde de silicium ayant une épaisseur d'environ 2,5 µm. En effet, la permittivité du silicium intrinsèque est environ égale à 3 fois la permittivité de l'oxyde de silicium. Ainsi, l'isolement vertical entre composant et substrat, formé par la structure de la figure 3, est équivalent à celui des structures connues sur substrat SOI, sans utilisation de tels substrats. L'homme de l'art déterminera aisément les dopages de la couche 35 et du substrat 31 pour obtenir une zone de charge d'espace dont l'épaisseur est comprise entre 3 µm et 10 µm, une telle épaisseur étant équivalente à une épaisseur d'oxyde enterré comprise entre 1 µm et 3,3 µm.

Les tranchées 41 pénètrent dans le substrat 31 sur une profondeur supérieure à l'épaisseur de la zone de charge d'espace dans le substrat 31. Ceci permet de limiter les capacités parasites entre deux composants voisins formés dans des caissons 33 voisins. En effet, si les tranchées isolantes 41 s'arrêtent à l'interface entre la couche 35 et le substrat 31, des capacités parasites élevées peuvent se former entre deux composants voisins, en dessous des tranchées isolantes 41. L'isolement entre les caissons est alors inefficace. La structure de la figure 3 permet d'éviter cela, les tranchées isolantes 41 formant un obstacle à la création de ces capacités parasites.

Ainsi, on obtient une structure isolée latéralement par une tranchée isolante 41. Cet isolement a, de façon connue, l'avantage d'assurer des capacités parasites faibles entre les composants et d'avoir un encombrement réduit (inférieur aux isolements par jonction). De plus, les caissons 33 sont isolés du substrat 31 par une jonction qui, contrairement aux préjugés, produit des effets identiques à ceux produits par une couche d'oxyde enterrée ayant une épaisseur de quelques micromètres. On réduit ainsi les capacités parasites entre composant et substrat, sans nécessiter l'utilisation d'une structure SOI coûteuse et susceptible de subir des déformations.

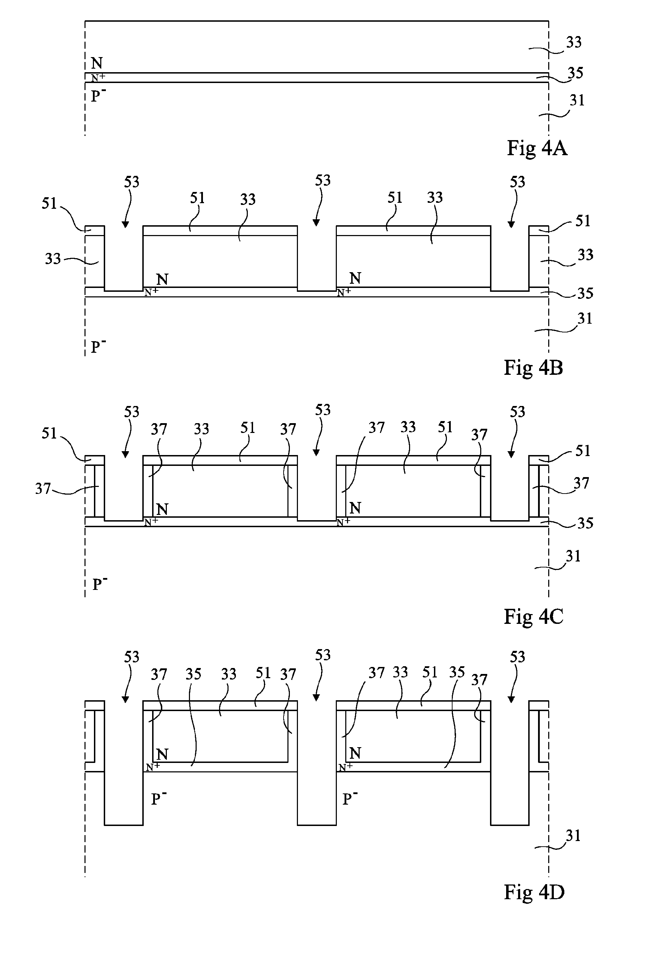

Les figures 4A à 4G illustrent des résultats d'étapes d'un procédé selon un mode de réalisation de la présente invention permettant d'obtenir la structure de la figure 3.

La figure 4A représente un substrat de silicium 31 faiblement dopé de type P (P⁻) sur lequel est formée une couche de silicium 35 fortement dopé de type N (N⁺). La couche 35 peut être formée, par exemple, en réalisant une implantation d'arsenic ou d'antimoine, et avoir une épaisseur, après diffusion, d'environ 5 µm. Sur la couche 35 est formée, par épitaxie, une couche épaisse 33 de silicium dopé de type N. A titre d'exemple, le substrat 31 peut être dopé à une concentration de dopants inférieure à 1,5.10¹³ atomes/cm³ et la couche 35 à une concentration de dopants de l'ordre de 10¹⁹ atomes/cm³. La couche 33 peut être dopée à une concentration de dopants de l'ordre de 2.10¹³ atomes/cm³ et avoir une épaisseur d'environ 10 µm.

A l'étape illustrée en figure 4B, on a formé, en surface de la couche de silicium 33, un masque 51 comprenant des ouvertures au travers desquelles on forme des tranchées 53 dans la couche de silicium supérieure pour former des caissons de silicium 33. Le masque 51 peut être, par exemple, en oxyde de silicium ou en nitrure de silicium. Les tranchées 53, résultant par exemple d'une gravure plasma, s'arrêtent dans la couche de silicium fortement dopé 35. En effet, la couche de silicium 35 ayant une épaisseur de quelques micromètres, elle permet un arrêt de la gravure de telle façon que la dispersion en profondeur de la gravure ne soit pas critique. A titre d'exemple de valeurs numériques, les tranchées 53 peuvent avoir une largeur comprise entre 1 et 2 µm.

A l'étape illustrée en figure 4C, on a formé, sur les parois des tranchées 53, un prédépôt 37 de POCl₃ permettant, lors d'une étape ultérieure de recuit, la formation de régions fortement dopées au phosphore (type N) sur les parois des caissons 33. On peut éventuellement ensuite réaliser une désoxydation pour éliminer l'oxyde formé en surface des parois des tranchées 53.

A l'étape illustrée en figure 4D, on procède à une nouvelle gravure plasma pour augmenter la profondeur des tranchées 53 pour que celles-ci traversent la couche de silicium 35 fortement dopé de type N et pénètrent dans le substrat 31 faiblement dopé de type P. Cette étape est réalisée à l'aide du masque 51. On réalise ensuite un recuit permettant au POCl₃ de diffuser dans les caissons de silicium 33 pour former des régions 37 fortement dopées de type N sur le haut des parois des tranchées 53, dans les caissons 33. On notera que le recuit pourra être réalisé avant l'étape de la figure 4D de formation de tranchées 53 profondes. A titre d'exemple, les tranchées 53 peuvent pénétrer dans le substrat 31 de silicium sur une profondeur comprise entre environ 10 µm et environ 15 µm, comme cela a été décrit ci-dessus.

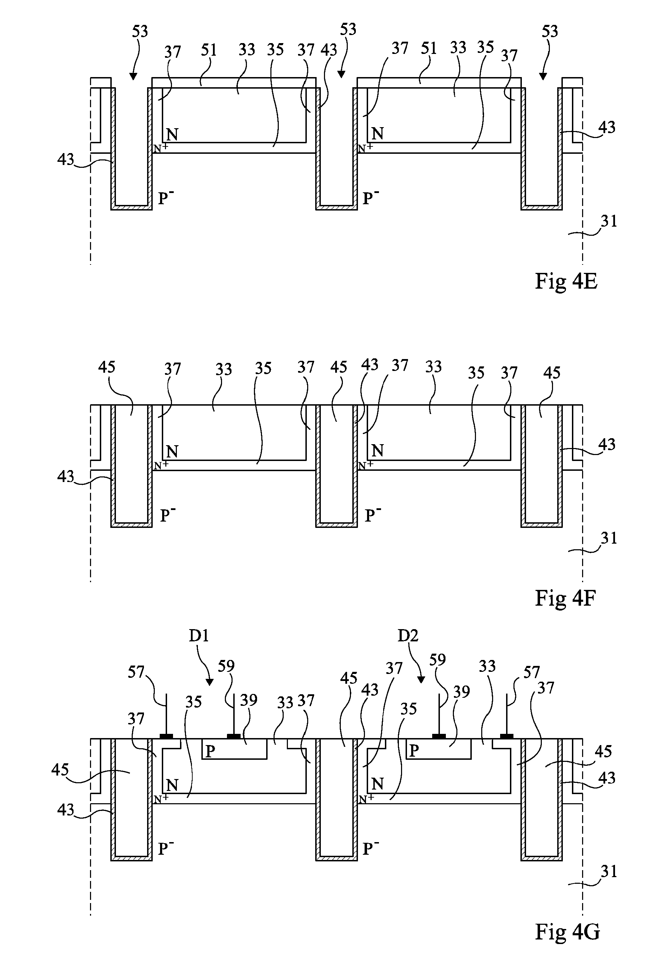

A l'étape illustrée en figure 4E, on a formé une fine couche isolante 43 sur les parois et le fond des tranchées 53, par exemple par oxydation thermique, pour former une couche d'oxyde de silicium 43.

A l'étape illustrée en figure 4F, on a rempli les tranchées 53 de silicium polycristallin ou de tout autre matériau 45 ayant de bonnes propriétés de comblement des tranchées 53, par exemple un oxyde. Le masque 51 est ensuite retiré.

A l'étape illustrée en figure 4G, on a formé des composants électroniques dans les caissons 33, dans l'exemple représenté des diodes D1 et D2 identiques à celle de la figure 3, qui comprennent des régions 39 dopées de type P formées en surface de chacun des caissons 33. Les régions 39 forment les anodes des diodes D1 et D2. Dans l'exemple représenté, des contacts 57 et 59 sont pris, respectivement, sur les régions de cathode 37 et d'anode 39 des diodes D1 et D2. Des régions fortement dopées de type N peuvent être formées en surface des caissons 33, au niveau des régions 37, pour aider à la formation des contacts de cathode 59.

Des modes de réalisation particuliers de la présente invention ont été décrits. Diverses variantes et modifications apparaîtront à l'homme de l'art. En particulier, on notera que les composants décrits ici ne sont que des exemples et que l'on pourra former d'autres composants dans les caissons isolés 33, par exemple des diodes de protection ou d'autres composants électroniques, par exemple des composants de puissance haute fréquence.

On notera également que l'on pourra concevoir des structures similaires à celles présentées ici en inversant tous les types de conductivité et les types de dopage.

## Revendications

1. Structure comprenant au moins un composant électronique formé dans un empilement semiconducteur comprenant une couche enterrée de silicium fortement dopé d'un premier type de conductivité (35) s'étendant sur un substrat de silicium faiblement dopé d'un second type de conductivité (31) et une tranchée isolante verticale (41) entourant le composant, **caractérisée en ce que** la tranchée (41) pénètre dans le substrat de silicium (31), en dessous de la couche de silicium (35), sur une profondeur supérieure à l'épaisseur de la zone de charge d'espace dans le substrat de silicium (31).

2. Structure selon la revendication 1, dans laquelle le substrat de silicium (31) est dopé à une concentration de dopants inférieure à 8,5.10¹³ atomes/cm³ et la couche de silicium enterrée (35) est dopée à une concentration de dopants supérieure à 10¹⁹ atomes/cm³.

3. Structure selon la revendication 1 ou 2, dans laquelle ladite zone de charge d'espace a une épaisseur comprise entre 1 µm et 3,3 µm.

4. Structure selon l'une quelconque des revendications 1 à 3, comprenant en outre des régions fortement dopées du premier type de conductivité (37) formées le long de la tranchée (41), au-dessus de la couche fortement dopée du premier type de conductivité (35).

5. Structure selon l'une quelconque des revendications 1 à 4, dans laquelle la tranchée isolante (41) a des parois isolées et est remplie de silicium polycristallin.

6. Structure selon l'une quelconque des revendications 1 à 5, dans laquelle le composant électronique est une diode (D1, D2) formée dans une couche de silicium supérieure (33) du premier type de conductivité s'étendant sur la couche de silicium fortement dopé du premier type de conductivité (35).

7. Structure selon l'une quelconque des revendications 1 à 6, dans laquelle le premier type de conductivité est le type N.

8. Procédé de fabrication d'une structure semiconductrice destinée à contenir un composant électronique (D1, D2), comprenant les étapes successives suivante :
former une couche de silicium supérieure (33) s'étendant sur un substrat de silicium (31) faiblement dopé d'un second type de conductivité avec interposition d'une couche enterrée de silicium fortement dopé (35) du premier type de conductivité ;
réaliser une tranchée (53), selon le contour du composant, dans la couche de silicium supérieure (33) ;
doper, du premier type de conductivité, les parois de la couche de silicium supérieure à partir de la tranchée (53) ;
prolonger la tranchée (53) dans le substrat de silicium (31), sur une profondeur supérieure à l'épaisseur de la zone de charge d'espace dans le substrat de silicium (31) ; et
former, sur les parois et le fond de la tranchée (53), une couche isolante (43).

9. Procédé selon la revendication 8, comprenant en outre une étape de comblement de la tranchée (53) par du silicium polycristallin (45).

10. Procédé selon la revendication 8 ou 9, dans lequel la couche enterrée de silicium fortement dopé (35) du premier type de conductivité est formée par implantation/diffusion de dopants en surface du substrat de silicium (31) et dans lequel la couche de silicium supérieure (33) est formée par épitaxie sur la couche de silicium enterrée (35).
